**Europäisches Patentamt**

(19) **European Patent Office**

**Office européen des brevets**

(11) Numéro de publication: **0 135 438**

**B1**

(12) **FASCICULE DE BREVET EUROPÉEN**

(45) Date de publication du fascicule du brevet: **20.05.87**

(51) Int. Cl.⁴: **H 01 R 13/514,** H 05 K 5/03

(21) Numéro de dépôt: **84401745.9**

(22) Date de dépôt: **31.08.84**

(54) Boîtier électrique connectable.

(30) Priorité: **14.09.83 FR 8314624**

(43) Date de publication de la demande:
**27.03.85 Bulletin 85/13**

(45) Mention de la délivrance du brevet:
**20.05.87 Bulletin 87/21**

(84) Etats contractants désignés:
**DE GB IT**

(56) Documents cité:
**FR-A-2 378 378**
**FR-A-2 410 934**
**FR-A-2 458 919**

(73) Titulaire: **DAV INDUSTRIES, Vétraz- Monthoux BP 85, F-74101 Annemasse Cédex (FR)**

(72) Inventeur: **Weber, Jacques, 9, Chemin des Batteries, F-74100 Vetraz- Montoux (FR)**

(74) Mandataire: **Levy, David, c/o S.A. Fedit- Loriot 38, avenue Hoche, F-75008 Paris (FR)**

LIBER, STOCKHOLM 1987

EP 0 135 438 B1

## Description

La présente invention concerne un boîtier électrique connectable et plus particulièrement un boîtier susceptible de renfermer des composants électroniques associés à un ou plusieurs circuits électriques tels que des circuits imprimés pris dans le sens large du terme,

et qui comporte des organes de connexion permettant de connecter ledit boîtier à d'autres circuits ou à d'autres boîtiers appelés d'interconnexion.

De tels boîtiers électriques sont généralement utilisés pour la commande d'équipements électriques tels que des essuie-glaces de voitures. Ces commandes d'équipements devenant de plus en plus perfectionnées, en raison des exigences de plus en plus grandes des constructeurs d'automobiles en vue d'améliorer le confort des usagers, il a été nécessaire d'introduire de nouveaux circuits spécifiques à telle ou telle fonction de la commande. Or, la multiplication des circuits entraîne une augmentation correspondante du volume nécessaire pour leur logement dans le compartiment moteur de la voiture. Tous les efforts tendent actuellement vers une optimisation des circuits électroniques et des composants associés, tout en maintenant un niveau de prix qui ne soit pas prohibitif. C'est ainsi qu'on utilise de plus en plus des circuits imprimés dans de tels boîtiers de commande. Les circuits imprimés utilisés peuvent être de différentes sortes, dérivés plus ou moins des circuits imprimés classiques.

Un premier type de circuit imprimé consiste en un empilage de plaques de circuits séparées les unes des autres par une feuille isolante accolée de préférence sur une plaque.

Un deuxième type de circuit consiste a relier entre eux plusieurs circuits par des conducteurs souples de manière à pouvoir replier le circuit dans plusieurs directions et permettre ainsi l'utilisation d'un plus grand nombre de composants.

Les deux types de circuits précités sont logés dans un capot, la face d'accès audit capot, le plus souvent le fond, étant ensuite fermée par une plaque de fond rapportée de manière à isoler l'interieur dudit capot et donc d'isoler lesdits circuits.

Le document FR-A- 2 378 378 décrit un dispositif modulaire d'interconnexion comportant une plaque support qui est repliée de façon à ce qu'une partie constitue un panneau avant et un panneau arrière reliés par leurs bords au moyen de plusieurs entretoises, montants ou colonnes.

Les panneaux sont préalablement découpés ou conformés pour recevoir des contacts ou d'autres connecteurs. Les plaquettes de circuit imprimé sont préparées indépendamment des plaques support auxquelles elles sont reliées par des soudures ou tout autre moyen équivalent.

Outre le fait que les circuits imprimés du premier type doivent présenter des caractéristiques dimensionnelles assez importantes si on veut faire passer des courants élevés, il faut noter que dans tous les cas la fabrication d'un boîtier de commande implique la fabrication et l'assemblage d'au moins trois éléments distincts, à savoir le capot, le circuit imprimé dans son sens le plus général, et la plaque de fond ou l'élément modulaire tel que décrit dans le brevet FR 2 378 378. Ceci conduit, en fabrication de grandes séries, à un prix de revient non négligeable pour des raisons qu'il est aisé de comprendre.

Par circuit électrique, il faut comprendre aussi bien les liaisons électriques et les composants électroniques que des composants électromécaniques comme par exemple des relais et/ou des éléments de connectique.

Un but de la présente invention est de réaliser un boîtier électrique connectable qui soit plus simple à fabriquer et donc d'un coût de revient plus faible.

Un autre but de la présente invention réside dans une nouvelle structure des circuits électriques qui permette non seulement des épaisseurs importantes de plaques mais encore un pliage dudit circuit dans plusieurs directions et donc plusieurs accès sur plusieurs faces, et également de pouvoir associer, éventuellement, des circuits électriques de structures différentes, en autorisant un empilage de plaques dans l'une des directions par exemple.

La présente invention a pour objet un boîtier électrique connectable, du type comportant un capot de protection (1), au moins une plaque circuit (3) recouverte d'isolant (9) sur au moins une de ses faces, des espaces dépourvus d'isolant étant ménagés dans la plaque circuit pour permettre une liaison électrique entre le circuit et des composants électriques ou électroniques (13 à 15), au moins une partie (4) de la plaque circuit (3) constituant le fond du capot de protection, caractérisé en ce que la partie de plaque formant le fond du capot est revêtue d'une couche d'isolant de grande épaisseur (9) dans laquelle sont ménagés des des logements (19) bordés par des parois surélevées (22) pour le passage et l'immobilisation des languettes de connexion (20).

Un avantage de la présente invention réside dans le fait que sous un volume réduit, on peut disposer un grand nombre de circuits accessibles sur plusieurs faces et capables de supporter des courants élevés, tout en ayant la possibilité de réaliser les liaisons électriques avec leur circuit support par une seule opération de soudure à la vague.

La présente invention a pour objet également un temporisateur de cadencement pour essuie-glace dont le circuit électronique est simplifié.

D'autres avantages et caractéristiques ressortiront mieux à la lecture de la description donnée à titre indicatif mais non limitatif de plusieurs modes de réalisation selon l'invention, dans une application d'un temporisateur de cadencement, ainsi que des dessins annexés sur lesquels:

la figure 1 est une vue en coupe du boîtier selon l'invention avec une plaque support de circuit repliée dans plusieurs directions.

La figure 2 est une vue en plan de la face externe d'une plaque support de circuit selon l'invention.

La figure 3 est une vue en coupe suivant III-III de la figure 2.

La figure 4 est une autre vue en coupe de la plaque support de la figure 2.

La figure 5 est une vue en coupe du boîtier selon un autre mode de réalisation comprenant deux types différents de support de circuit.

La figure 6 est une représentation du circuit électronique de temporisation de cadencement.

Le boîtier, selon l'invention, comprend un capot 1, de forme parallélépipédique par exemple et ouvert sur le fond 2. Le capot est en une matière appropriée isolante telle que de la matière plastique.

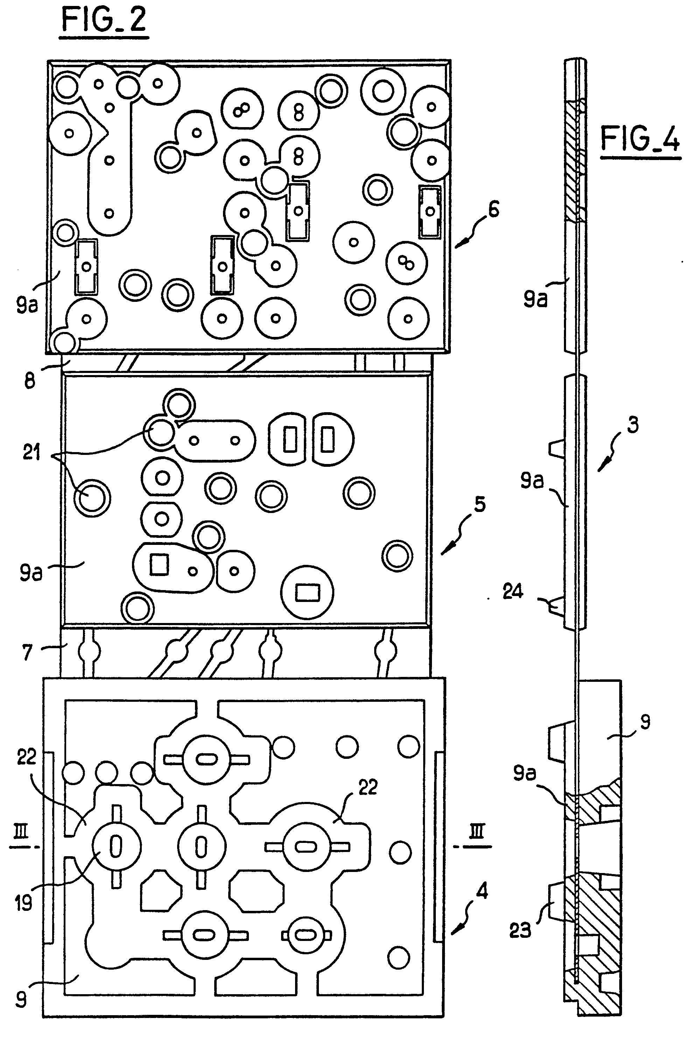

A l'intérieur du capot 1 est disposé un circuit imprimé, désigné dans son ensemble par la référence 3 et dont le détail de construction sera donné à l'appui des figures 2 à 4. Le circuit imprimé 3 comprend trois parties 4, 5, 6 situées dans des plans différents définis par deux pliages dans les zones 7 et 8 de façon que les parties 4 et 5 soient situées en regard l'une de l'autre, tandis que la partie 6 est dans un plan sensiblement perpendiculaire aux plans des parties 4 et 5. Chacune des parties 4 à 6 du circuit imprimé 3 est revêtue sur au moins une face par un isolant 9. Toutefois l'isolant de la partie 4 est disposé sur la face externe et présente une épaisseur supérieure à celle de l'isolant des parties 5 et 6. La partie 4 et son isolant comportent des moyens pour les rendre solidaires du capot 1 de manière à constituer le fond dudit capot. De tels moyens peuvent être constitués par un rebord périphérique 10 ménagé dans l'isolant 9 et s'encliquetant dans une rainure périphérique 11 ménagée à l'extrémité inférieure des parois latérales du capot 1. Le calage et l'immobilisation de la partie 4 avec son isolant 9 sont également assurés par un appui du rebord 10 sur un rebord interne 12 prévu à la base des parois latérales du capot 1.

Des composants électromécaniques et/ou électroniques tels qu'un relais 13, des condensateurs 14 et des résistances 15 sont connectés aux parties 5 et 6 du circuit imprimé 3.

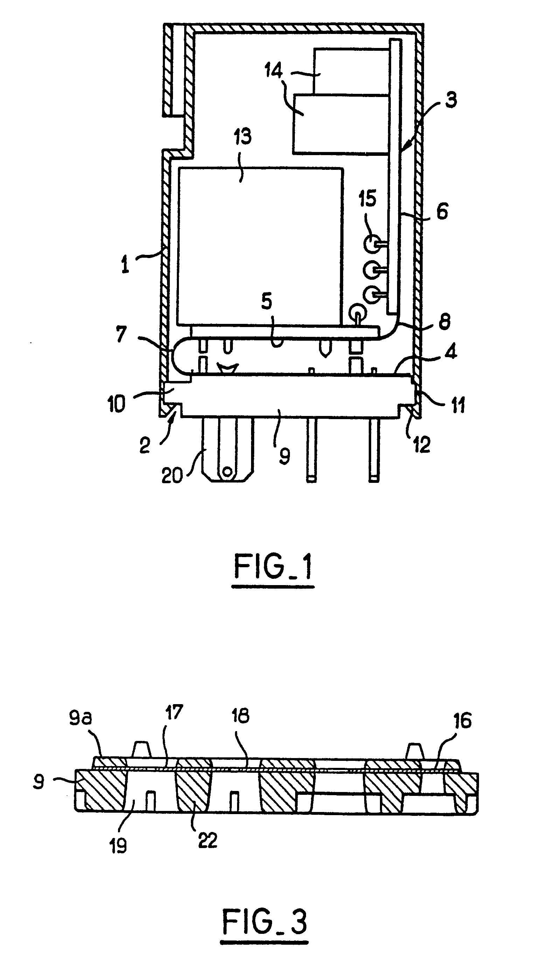

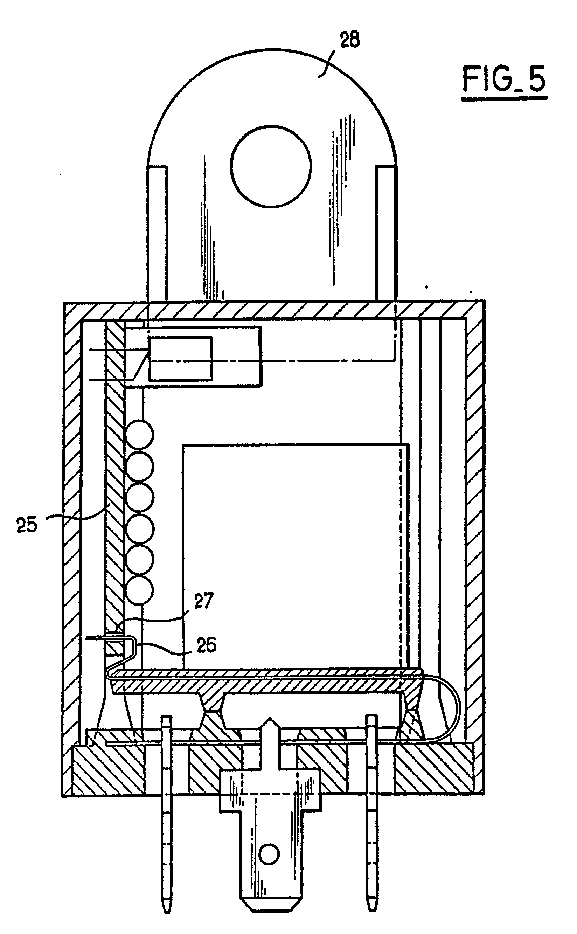

Le circuit imprimé 3 comprend (figures 2 et 3) une plaque métallique 16, d'épaisseur appropriée, dans laquelle sont découpés des circuits 17 délimitant entre eux des passages 18. Le découpage des circuits ou pistes métalliques peut être chimique ou plus économiquement mécanique avec récupération des déchets. Les deux faces de la plaque 16 sont recouvertes dans leur majeure partie par un isolant 9a sauf à certains endroits et notamment autour d'orifices 19 prévus pour le positionnement de broches de connexion 20 (figure 1) ou d'orifices 21 pour la connexion des composants électroniques 13 à 15 à la plaque 16. Pour plus de détail sur la structure de base et le procédé de fabrication d'un tel circuit imprimé on pourra utilement se reporter à une demande de brevet déposée au nom de la demanderesse et relative à un "Circuit imprimé pour courants élevés".

Une des caractéristiques de ce circuit imprimé réside dans le fait qu'il comprend une partie d'isolant plus épaisse 9 pour constituer le fond du capot 1, les orifices 19 pour le passage des broches ou plus exactement de languettes de connexion plates 20 étant bordés par des parois surélevées 22 qui contribuent à une meilleure rigidification dudit fond de capot tout en assurant un guidage et un maintien desdites languettes 20. Bien évidemment les orifices 19 peuvent être de dimensions différentes, en fonction des dimensions des languettes 20 à connecter avec la plaque 16, comme cela apparaît clairement sur les figures 2 à 4.

La plaque 16 est, en outre, dépourvue d'isolant, sur ses deux faces, dans les zones de pliage 7 et 8 de manière à pouvoir obtenir une configuration du circuit imprimé 3 dans plusieurs directions, comme cela ressort de la figure 1.

En se référant à la figure 4, on peut constater que le circuit imprimé 3 comprend, sur sa face interne par opposition à la face externe sur laquelle est prévue en partie la surépaisseur d'isolant 9, des entretoises 23 et 24; les entretoises 23 sont disposées sur la partie 4 du circuit 3 et dans une direction, tandis que les entretoises 24 sont disposées sur la partie 5 dudit circuit et dans une direction perpendiculaire à celle des entretoises 23, de façon que lorsque le circuit 3 est plié et que les parties 4 et 5 viennent en regard, les entretoises 23 et 24 coopèrent entre elles pour constituer des butées, limitant ainsi un espace entre lesdites parties 4 et 5. De plus, les entretoises 23 et 24 servent à produire un isolement entre les parties 4 et 5 ainsi que le positionnement du circuit 3 dans le capot 1.

Enfin, il faut noter qu'avec un tel circuit imprimé 3, les liaisons entre la plaque métallique 16 et les éléments de connectique tels que les languettes de connexion 20, ainsi que les composants électroniques, sont faites en un seul passage par un procédé de soudure dit à la vague et décrit dans la demande mentionnée précédemment.

Sur la figure 5, on a représenté un autre mode de réalisation de l'invention qui diffère de celui de la figure 1, par le fait que le circuit imprimé 3 ne comporte que les deux parties 4 et 5 avec leurs caractéristiques décrites à l'appui des figures 2 et 4, et par le fait que la partie 6 est constituée par un circuit imprimé classique 25. Dans ce deuxième mode de réalisation, la liaison électrique entre les circuits imprimés 3 et 25 est assurée par une extrémité 26 de la plaque métallique 16 du circuit imprimé 3, ladite extrémité étant repliée de manière à pouvoir être insérée dans une fente (27) ménagée à cet effet dans le circuit 25 qui est relié au circuit 3 par soudure à la vague en même temps que les composants électroniques et les éléments de connectique. Enfin une patte de fixation 26, également prévue pour le boîtier du premier mode de réalisation mais non représentée sur la figure 1, sert à la fixation du boîtier sur un organe de support non représenté.

Les deux modes de réalisation du boîtier selon l'invention ne sont pas limitatifs. On peut par exemple réaliser un boîtier dans le capot duquel on dispose un empilage de plaques circuit dont la nature peut être identique ou différente, les languettes de connexion 20 présentant alors des hauteurs telles qu'à chaque plaque circuit corresponde un type de languettes. La soudure des languettes de connexion avec sa plaque correspondante est réalisée par soudure à la vague également. En pratique, on réalise la liaison de la plaque de fond avec les languettes de connexion les plus courtes, puis on dispose la deuxième plaque au-dessus de ladite plaque de fond, à une distance appropriée, et on la soude avec les languettes correspondantes, puis on continue successivement de la même manière avec les autres plaques de l'empilage.

On peut également utiliser un circuit imprimé 3 tel que celui représenté sur la figure 1 et relier la partie 5 à un ou plusieurs autres circuits imprimés dont la nature peut être celle justement du circuit imprimé 3 et/ou celle du circuit imprimé 25 représenté sur la figure 5. Toutes les combinaisons de plaques sont possibles dès lors que le fond du capot de protection est constitué par la dernière plaque inférieure de l'empilage, laquelle serait revêtue sur sa face externe par un isolant d'épaisseur appropriée.

On pourrait même prévoir dans l'épaisseur d'isolant de la plaque de fond des logements de structure analogue à celle des logements 19 et dans lesquels on logerait des composants électroniques.

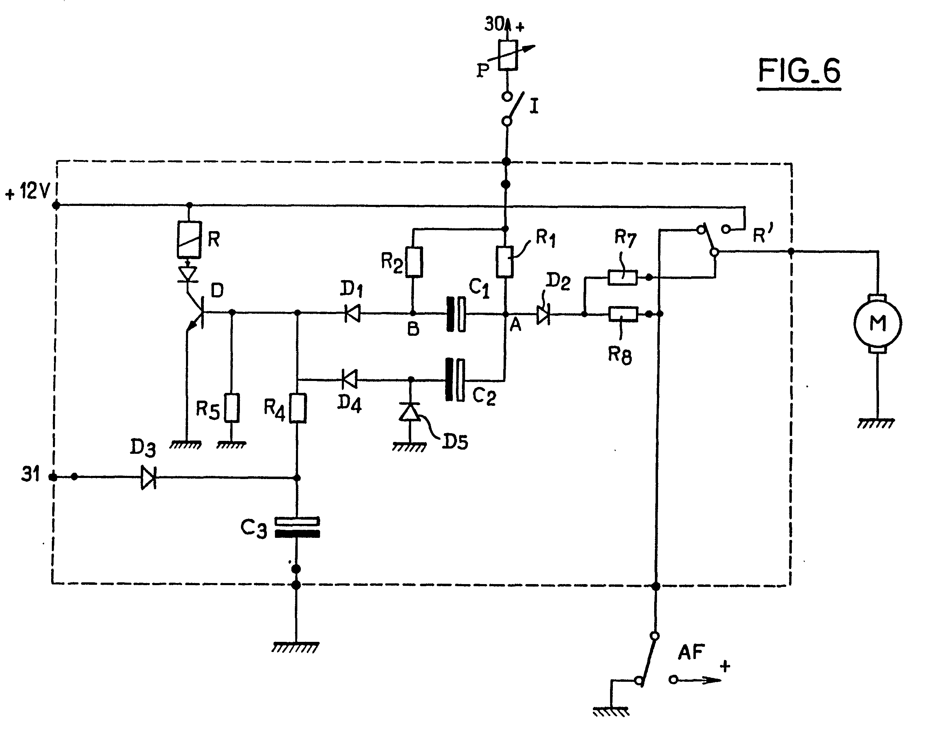

Le circuit électronique du temporisateur de cadencement est représenté sur la figure 6, et sera décrit par son fonctionnement.

Avant de décrire le fonctionnement du circuit de temporisation, il est nécessaire de rappeler que la commande à petite ou grande vitesse des balais d'essuie-glace est réalisée à partir de moyens séparés et qui se seront pas décrits pour être bien connus des spécialistes.

Lorsque le conducteur enclenche la commande de marche cadencée, cela produit la fermeture d'un contact I d'intermittence, reliant ainsi un condensateur $C_1$ par l'intermédiaire d'une résistance $R_1$ à la borne positive 30 d'une source d'alimentation. Une impulsion de commande est alors délivrée à la base d'un Darlington D, à travers une diode $D_1$. Le Darlington D étant conducteur, un relais R est actionné et son contact R' bascule, permettant à l'alimentation 12 V d'être reliée au moteur d'essuie - glace M qui est mis en rotation. Un contact AF (Arrêt-Fixe) est relié au moteur, de façon connue en soi, par exemple au moyen d'une came, et passe cycliquement, à chaque tour du moteur M, d'un contact relié à la masse à la borne plus.

Pendant la durée du balayage des essuie-glaces, le condensateur $C_1$ se charge et le Darlington reste alimenté par la résistance $R_2$. A chaque retour du contact AF à la masse, le potentiel du point A et par suite, par le condensateur $C_1$ chargé, celui du point B diminue jusqu'à une valeur négative. Dans ces conditions, le Darlington se bloque et le relais n'est plus actionné. Il faut noter que la mise à la masse d'une résistance $R_7$ d'un pont $R_7$-$R_8$ associé au contact R' accentue encore l'abaissement du potentiel en A.

La temporisation de cadencement s'effectue donc par décharge progressive du condensateur $C_1$. La constante de temps dépend essentiellement de $R_2$ et $C_1$.

Il va de soi que lorsque le contact I est ouvert, le condensateur $C_1$ se décharge à travers la résistance $R_2$ et le Darlington se bloque.

Lorsque le conducteur commande l'aspersion de liquide sur une glace à nettoyer, une impulsion électrique est simultanément appliquée au point 31 et la tension appliquée à travers une diode $D_3$ à un condensateur $C_3$ permet à ce dernier de se charger et au Darlington D d'être conducteur, ce qui commande, par l'intermédiaire du relais R, la mise en rotation du moteur M. La capacité du condensateur $C_3$ est telle que la décharge progressive à travers $R_4$ et $R_5$ permet d'assurer par exemple trois balayages des balais sur la glace.

Une caractéristique de ce circuit réside dans le fait que la branche $D_3$-$C_3$-$R_4$ est montée sur le circuit principal de temporisation décrit ci-dessus, permettant ainsi une économie de composants puisqu'il n'y a pas deux circuits distincts. On utilise, de ce fait, un seul Darlington D.

Une autre caractéristique dudit circuit réside dans l'adjonction d'une branche électronique $C_2$-$D_4$-$D_5$ dont la fonction est explicitée ci-dessous.

Lorsque le contact d'intermittence I est ouvert puis fermé de façon rapprochée, ou tout au moins lorsque la fermeture suit l'ouverture avant que le condensateur $C_1$ ne soit totalement déchargé, la re-initialisation de la marche cadencée des balais d'essuie-glace ne devrait pouvoir être effectuée qu'après la décharge totale du condensateur $C_1$. En d'autres termes, deux excitations rapprochées du Darlington D sont fonction de l'état antérieur du condensateur $C_1$. Il s'ensuit une durée brève pendant laquelle les balais d'essuie-glace restent au repos malgré la fermeture du contact 1. La conséquence en est un manque de confort pour l'usager. Pour améliorer donc le confort de l'usager, le circuit comprend un condensateur $C_2$ et une diode $D_4$ qui sont montés en parallèle sur la partie du circuit $C_1$-$D_1$. Ainsi, lorsque le condensateur se trouve dans un état qui ne permet pas l'excitation immédiate du Darlington D, l'ordre d'excitation, donné par la nouvelle fermeture du contact I, transite par $C_2$-$D_4$ qui prend en quelque sorte le relais de $C_1$-$D_1$, jusqu'à ce que $C_1$-$D_1$ soit à

nouveau capable de remplir sa fonction. Une diode D$_5$ permet la décharge rapide du condensateur C$_2$.

Enfin, et bien qu'elle ne soit pas représentée sur la figure 6, une capacité peut être montée en parallèle sur le moteur M pour éviter les parasites, diminuer la production d'étincelles et certains défauts de fonctionnement.

**Revendications**

1. Boîtier électrique connectable, du type comportant un capot de protection (1), au moins une plaque circuit (3) recouverte d'isolant (9) sur au moins une de ses faces, des espaces dépourvus d'isolant étant ménagés dans la plaque circuit pour permettre une liaison électrique entre le circuit et des composants électriques ou électroniques (13 à 15), au moins une partie (4) de la plaque circuit (3) constituant le fond du capot de protection, caractérisé en ce que la partie de plaque formant le fond du capot est revêtue d'une couche d'isolant de grande épaisseur (9) dans laquelle sont ménagés des logements (19) bordés par des parois surélevées (22) pour le passage et l'immobilisation des languettes de connexion (20).

2. Boîtier selon la revendication 1, caractérisé en ce que la partie de plaque (4) constituant le fond du capot de protection est revêtue sur la face externe de la plaque d'une couche d'isolant (9) dont l'épaisseur est supérieure à celle de la couche d'isolant (9a) disposée sur la face interne de ladite plaque.

3. Boîtier selon les revendications 1 ou 2, caractérisé en ce que la plaque (3) est revêtue sur la face interne d'une couche d'isolant (9a), d'épaisseur constante.

4. Boîtier selon l'une des revendications 1 à 3, caractérisé en ce que la plaque circuit comprend des zones (7, 8) dépourvues d'isolant sur les deux faces, de manière à permettre le pliage de ladite plaque le long des dites zones et dans des directions différentes.

5. Boîtier selon la revendication 4, caractérisé en ce que la plaque circuit comprend sur la face interne des entretoises isolantes (23, 24), de façon que lorsque ladite plaque est pliée, lesdites entretoises constituent des organes de butée de manière à produire un isolement entre les parties de plaque pliées en regard et à positionner le circuit dans le capot de protection.

6. Boîtier selon la revendication 1, caractérisé en ce que les languettes de connexion (20) sont reliées au circuit de la plaque par une soudure à la vague.

7. Boîtier selon l'une des revendications 1 à 6, caractérisé en ce qu'il comprend un empilage de plaques circuit et en ce que certaines des languettes de connexion présentent des hauteurs différentes, chaque série de languettes étant affectée à une même plaque circuit dudit empilage.

8. Boîtier selon l'une des revendications 1 à 6, caractérisé en ce qu'il comprend une première plaque circuit repliable dont une extrémité est dépourvue d'isolant sur les deux faces, et une deuxième plaque circuit de nature différente de ladite première plaque circuit, l'extrémité dénudée (26) de la première plaque étant introduite dans un logement (27) ménagé dans la deuxième plaque circuit et dans lequel est effectuée une liaison électrique entre les circuits électriques des première et deuxième plaques.

9. Boîtier selon l'une des revendications 1 à 8, caractérisé en ce qu'il constitue un temporisateur de cadencement d'un essuie-glace.

10. Boîtier selon la revendication 9, caractérisé en ce que le temporisateur comprend un circuit de temporisation d'intermittence et un circuit d'initialisation monté en parallèle sur ledit circuit d'intermittence et connecté à la base d'un transistor de commande.

11. Boîtier selon l'une des revendications 8 ou 10, caractérisé en ce qu'il comprend un autre circuit de temporisation commandé par une pression d'un lave-glace et connecté à la base du transistor de commande.

**Patentansprüche**

1. Anschließbares elektrisches Gehäuse, das als Schutzkappe (1) ausgebildet ist, wobei wenigstens eine Schaltkreisplatte (3) vorhanden ist, die auf wenigsten einer Seite mit einer Isolierung (9) versehen ist und Räume existieren, die frei von der Isolierung sind, um eine elektrische Verbindung zwischen dem Schaltkreis und elektrischen oder elektronischen Komponenten (13 bis 15) zu ermöglichen, und wobei wenigstens ein Teil (4) der Stromkreisplatte (3) den Boden der Schutzkappe bildet, dadurch gekennzeichnet, daß der Teil der Platte, der den Boden der Schutzkappe bildet, mit einer Isolierschicht (9) großer Dicke versehen ist, in welcher Ausnehmungen (19) vorhanden sind, die zum Durchtritt und zur Sperrung von Kontaktelementen (20) von erhöhten Wandabschnitten (22) begrenzt sind.

2. Gehäuse nach Anspruch 1, dadurch gekennzeichnet, daß der den Boden der Schutzkappe bildende Teil (4) der Platte an der Außenseite der Platte mit einer Isolierschicht (9) versehen ist, deren Dicke größer ist als die Isolierschicht (9a), die sich auf der Innenseite der Platte befindet.

3. Gehäuse nach Anspruch 1 oder 2, dadurch gekennzeichnet, daß die Platte (3) auf der Innenseite mit einer Isolierschicht (9a) gleichmäßiger Dicke versehen ist.

4. Gehäuse nach einem der Ansprüche 1 bis 3, dadurch gekennzeichnet, daß die Stromkreisplatte Zonen (7, 8) aufweist, die zum Biegen der Platte in den Zonen in verschiedenen Richtungen an ihren beiden Flächen keine Isolierung aufweist.

5. Gehäuse nach Anspruch 4, dadurch gekennzeichnet, daß die Stromkreisplatte an ihrer Innenfläche Isolierstege (23, 24) aufweist, die im gefalteten Zustand der Platte Anschläge zur Isolation zwischen umgebogenen gegenüberliegenden Plattenteilen und zur Positionierung innerhalb der Schutzkappe bilden.

6. Gehäuse nach Anspruch 1, dadurch gekennzeichnet, daß die Kontaktelemente (20) durch Löten an die Stromkreisplatte angeschlossen sind.

7. Gehäuse nach einem der Ansprüche 1 bis 6, dadurch gekennzeichnet, daß es einen Stapel von Schaltkreisplatten enthält und daß gewisse Kontaktelemente unterschiedliche Höhen aufweisen, wobei jede Kontaktserie derselben Stromkreisplatte zugeordnet ist.

8. Gehäuse nach einem der Ansprüche 1 bis 6, dadurch gekennzeichnet, daß es eine erste biegsame Stromkreisplatte aufweist, deren eines äußeres Ende auf seinen beiden Seiten mit keiner Isolierung versehen ist, und daß es eine zweite Schaltkreisplatte aufweist, die sich von der ersten Stromkreisplatte unterscheidet, wobei das isolierfreie äußere Ende (26) der ersten Schaltkreisplatte zur elektrischen Verbindung der ersten und zweiten Stromkreisplatte in eine Ausnehmung (27) der zweiten Stromkreisplatte eingreift.

9. Gehäuse nach einem der Ansprüche 1 bis 8, dadurch gekennzeichnet, daß es eine Zeitschalteinrichtung eines Scheibenwischers umfaßt.

10. Gehäuse nach Anspruch 9, dadurch gekennzeichnet, daß die Zeitschalteinrichtung aus einem Zeitunterbrecherschaltkreis und einem Initialschaltkreis besteht, der parallel über dem Zeitunterbrecherschaltkreis angeordnet und mit der Basis eines Steuerungstransistors verbunden ist.

11. Gehäuse nach einem der Ansprüche 8 bis 10, dadurch gekennzeichnet, daß es eine weitere Zeitschalteinrichtung aufweist, die durch den Druck eines Scheibenwaschers gesteuert und mit der Basis des Steuerungstransistors verbunden ist.

## Claims

1. Connectable electrical box of a type comprising a protective cap (1), at least one circuit board (3) covered in isolating material (9) on at least one of its surfaces, spaces free of isolating material being provided on the circuit board to enable an electrical connection to be made between the circuit and electrical or electronic components (13 to 15), at least one part (4) of circuit board (3) forming the base of the protective cap, characterised in that the part of the board forming the base of the cap is covered with a thick layer of isolating material (9) in which there are placements (19) edged by raised walls (22), for the passage and immobilisation of connection terminals (20).

2. Box according to claim 1, characterised in that the part of the board (4) forming the base of the protective cap is covered on the external surface of the board with a layer of isolating material (9) which is thicker than the layer of isolating material (9a) on the internal surface of said board.

3. Box according to one of claims 1 to 3 characterised in that the board (3) is covered on its internal surface with a constant layer of isolating material.

4. Box according to one of claims 1 to 3 characterised in that the circuit board includes areas (7, 8) free from isolating material on both surfaces, in order to permit the folding of the board along these areas and in different directions.

5. Box according to claim 4, characterised in that the circuit board has on its internal surface isolating braces (23, 24), so that when the said board is folded, said braces form abutment stops to isolate the parts of the folded board facing each other and to position the board in the protective cap.

6. Box according to claim 1, characterised in that the connection terminals (20) are linked to the circuit on the board by means of wave soldering.

7. Box according to one of claims 1 to 6 characterised in that it contains a stack of circuit boards and that certain connection terminals have different heights, each series of terminals being assigned to one circuit board in said stack.

8. Box according to one of claims 1 to 6 characterised in that it contains a first circuit board which can be folded and at one end is free of isolating material on both surfaces, and a second circuit board of a different type from the first circuit board, the free end (26) of first circuit board being introduced into a placement (27) arranged in the second circuit board and in which an electrical connection is made between the electrical circuits of the first and second boards.

9. Box according to one of claims 1 to 8 characterised in that it forms a cadence retarder for a windscreen wiper.

10. Box according to claim 9, characterised in that the retarder comprises an intermittance retarder circuit and an initialisation circuit arranged in parallel on said intermittance circuit and connected to the base of a control transistor.

11. Box according to one of claims 8 or 10 characterised in that it comprises another retarder circuit controlled by the pressure of a windscreen washer and connected to the base of the control transistor.

$$\underline{\text{FIG.1}}$$

$$\underline{\text{FIG.3}}$$

**FIG. 2**

**FIG. 4**

FIG. 5

FIG.6

30A+

+12V

31

0 135 438

7